# EUROPEAN PATENT APPLICATION

(11) **EP 4 812 010 A1**
(43) Date of publication of application: **23.09.2026**
(21) Application number: 26156848.9
(22) Date of filing: 06.02.2026
(51) Int. Cl.: H10W 74/01, H10W 70/695, H10W 74/10, H10W 74/15, H10W 90/00, H10W 90/10, H10W 90/20, H10W 76/63

(54) **SEMICONDUCTOR PACKAGE INCLUDING A REDISTRIBUTION SUBSTRATE**

(30) Priority: 19.03.2025 KR 20250035137
(71) Applicant: SK hynix Inc., Bubal-eub Icheon-si Gyeonggi-do 17336 (KR)
(72) Inventor: PARK, Wan Choon, 17336 Icheon-si, Gyeonggi-do (KR); BAE, Han Jun, 17336 Icheon-si, Gyeonggi-do (KR)
(74) Representative: Isarpatent

(57) **Abstract**

A semiconductor package according to embodiments of the present disclosure includes a package substrate; a redistribution substrate bonded to the package substrate by a first bump, and including a dielectric layer and redistribution patterns; a first underfill layer filled in the space between the package substrate and the redistribution substrate; a semiconductor chip bonded to the redistribution substrate by a second bump; and a first molding layer disposed on the redistribution substrate, and surrounding the semiconductor chip, wherein the dielectric layer includes a negative tone dielectric layer that includes polyimide at a mass ratio of 50% or more.

## Description

### BACKGROUND

### 1. Technical Field

Embodiments of the present disclosure generally relate to a semiconductor technology, and more particularly, to a semiconductor package including a redistribution substrate.

### 2. Related Art

A semiconductor chip includes an integrated circuit for storing data or processing data. In addition, the semiconductor chip includes a chip pad for inputting data to the integrated circuit or outputting data of the integrated circuit to the outside. A semiconductor package serves to electrically connect the semiconductor chip to an external device.

Various methods may be applied to electrically connect the chip pad to the external device. A redistribution substrate has a redistribution pattern that is electrically connected to the chip pad. Among semiconductor packages using redistribution substrates, a fan-out package is a technology that extends the redistribution pattern of a redistribution substrate to the outside of an area where a semiconductor chip is disposed and disposes an external connection terminal on the redistribution pattern. The fan-out package enables the implementation of high-density I/O (input/output) because the number and pitch of external connection terminals are not limited by the size of the semiconductor chip.

### SUMMARY

In an embodiment, a semiconductor package may include: a package substrate; a redistribution substrate bonded to the package substrate by a first bump, and including a dielectric layer and redistribution patterns; a first underfill layer filled in the space between the package substrate and the redistribution substrate; a semiconductor chip bonded to the redistribution substrate by a second bump; and a first molding layer disposed on the redistribution substrate, and surrounding the semiconductor chip, wherein the dielectric layer includes a negative tone dielectric layer that includes polyimide at a mass ratio of 50% or more.

In an embodiment, a semiconductor package may include: a package substrate; a redistribution substrate bonded to the package substrate by a first bump, and including a dielectric layer and a redistribution pattern; and a first semiconductor chip bonded to the redistribution substrate by a second bump, wherein the dielectric layer includes a negative tone dielectric layer that includes polyimide at a mass ratio of 50% or more.

### BRIEF DESCRIPTION OF THE DRAWINGS

The disclosure will be more fully understood from the following detailed description and the accompanying drawings, which are provided for illustration only and are not intended to limit the disclosure.

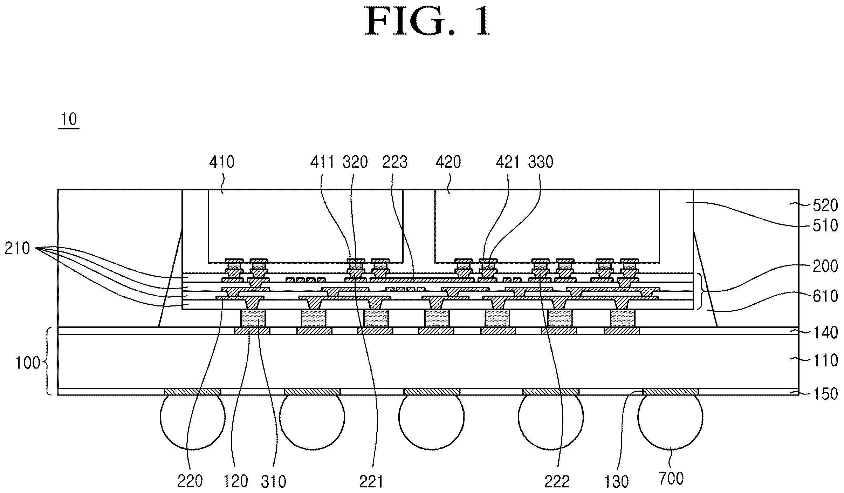

FIG. 1, FIG. 2, FIG. 3, and FIG. 4 are cross-sectional views illustrating semiconductor packages according to embodiments of the present disclosure.

### DETAILED DESCRIPTION

Embodiments of the present disclosure are described detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," "under," or "beneath" another element, the elements may directly contact each other or an intervening element may be disposed between the elements.

Terms such as "vertical," "horizontal," "top," "bottom," "above," "below," "under," "beneath," "over," "on," "side," "upper," "uppermost," "lower," "lowermost," "front," "rear," "left," "right," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example. As used herein, the term "and/or" includes any and all combinations of one or more of the associated listed items.

In the description, when an element included in an embodiment is described in singular form, the element may be interpreted to include a plurality of elements performing the same or similar functions.

FIG. 1 is a cross-sectional view illustrating a semiconductor package according to an embodiment of the present disclosure.

Referring to FIG. 1, a semiconductor package 10 according to an embodiment of the present disclosure includes a package substrate 100, a redistribution substrate 200, a first semiconductor chip 410, and a second semiconductor chip 420. The semiconductor package 10 according to the embodiment of the present disclosure further includes a first molding layer 510, a second molding layer 520, a first underfill layer 610, and an external connection terminal 700.

The package substrate 100 includes a substrate body 110, an upper substrate pad 120, a lower substrate pad 130, an upper insulating layer 140, and a lower insulating layer 150.

The substrate body 110 may include a plurality of insulating layers and a plurality of wirings. Although not illustrated, the plurality of insulating layers may include a core insulating layer, a first substrate insulating layer that is disposed on the core insulating layer, and a second substrate insulating layer that is disposed under the core insulating layer. The wirings may each include a through via that penetrates the core insulating layer, an upper conductive pattern that is disposed on the upper surface of the core insulating layer, and a lower conductive pattern that is disposed under the lower surface of the core insulating layer.

The core insulation layer may have a coefficient of thermal expansion of 2.5 ppm/°C to 19 ppm/°C (parts per million per degree Celsius). The core insulating layer may have a glass transition temperature (Tg) of 170°C to 240°C. The core insulation layer may have a Young's modulus of 10 GPa to 36 GPa (Gigapascals). In an embodiment, the coefficient of thermal expansion for a layer is a measure of how much the material expands or contracts with changes in temperature. For example, the coefficient of thermal expansion may equal a change in length divided by the multiplication of the original length and the change in temperature.

The first and second substrate insulating layers may include prepreg (e.g., pre-impregnated composite fiber). The first and second substrate insulating layers may have a coefficient of thermal expansion of 5 ppm/°C to 19 ppm/°C. The first and second substrate insulating layers may have a glass transition temperature of 160°C to 240°C. The first and second substrate insulating layers may have a Young's modulus of 12 GPa to 26 GPa.

The upper substrate pad 120 is disposed on the upper surface of the substrate body 110. The lower substrate pad 130 is disposed under the lower surface of the substrate body 110. The upper substrate pad 120 and the lower substrate pad 130 may be parts of the circuit and/or wiring structure of the package substrate 100.

The upper insulating layer 140 is disposed on the upper surface of the substrate body 110, and is configured to expose the upper substrate pad 120. The lower insulating layer 150 is disposed under the lower surface of the substrate body 110, and is configured to expose the lower substrate pad 130.

The upper insulating layer 140 and the lower insulating layer 150 may include photosensitive solder resist (PSR). The upper insulating layer 140 and the lower insulating layer 150 may have a coefficient of thermal expansion of 15 ppm/°C to 60 ppm/°C. The upper insulating layer 140 and the lower insulating layer 150 may have a glass transition temperature of 100°C to 160°C. The upper insulating layer 140 and the lower insulating layer 150 may have a Young's modulus of 3.3 GPa to 7.8 GPa.

The redistribution substrate 200 is mounted on the package substrate 100 by a first bump 310. The redistribution substrate 200 is electrically and physically connected to the package substrate 100 by the first bump 310.

The redistribution substrate 200 includes dielectric layers 210 and redistribution patterns 220. The redistribution substrate 200 may be a multi-layered redistribution layer (RDL). The dielectric layer 210 may be composed of a negative tone dielectric (NTD) that includes polyimide at a mass ratio of 50% or more.

The dielectric layer 210 may have a coefficient of thermal expansion of 20 ppm/°C to 50 ppm/°C. The dielectric layer 210 may have a glass transition temperature higher than the glass transition temperature of the first underfill layer 610. In one embodiment, the glass transition temperature of the dielectric layer 210 may be 200°C or higher. In other embodiments, the glass transition temperature of the dielectric layer 210 may be 200°C to 220°C. In one embodiment, the tensile strength of the dielectric layer 210 may be 500 MPa or more. In other embodiments the tensile strength of the dielectric layer 210 may be 500 MPa to 700 MPa (megapascals). In one embodiment, the elongation of the dielectric layer 210 may be 50% or more. In other embodiments, the elongation of the dielectric layer 210 may be 70% or more. In an embodiment, elongation of a dielectric layer may refer to the material's ability to stretch or deform under tensile stress before breaking. In some embodiments, the elongation percentage is calculated as the difference between a length as break and an original length, divided by the original length, and then multiplied by one hundred. In an embodiment, tensile strength refers to the maximum amount of tensile (pulling) stress the material can withstand before breaking or failing. For example, a higher tensile strength means the dielectric material is stronger and can resist greater forces without tearing or cracking. In an embodiment, a glass transition temperature (Tg) of a dielectric layer is the temperature at which the material transitions from a rigid, glassy state to a soft, rubbery state. For example below Tg, the layer is hard, stiff, and brittle. For example, above Tg, the layer becomes softer, more flexible, and can lose mechanical and dimensional stability. In an embodiment, the Tg marks a phase transition in polymer behavior, not a solid-to-liquid change.

The redistribution patterns 220 may be metal wirings. The metal wiring may include copper (Cu). The redistribution patterns 220 each include a via section and a wiring section. The via section may be a component for vertical connection, and the wiring section may be a component for horizontal connection. The via section vertically penetrates a corresponding dielectric layer 210. The wiring section is disposed on the via section and the dielectric layer 210. The width of the wiring section may be larger than the width of the via section. The via section and the wiring section may be formed integrally.

The redistribution patterns 220 each include a first UBM pad 221, a second UBM pad 222, and a connection pattern 223. The first and second UBM pads 221 and 222 may be provided in an uppermost dielectric layer 210, and may extend onto the upper surface of the uppermost dielectric layer 210. The upper surface of the first UBM pad 221 and the upper surface of the second UBM pad 222 may not be covered with the uppermost dielectric layer 210. The connection pattern 223 connects the first UBM pad 221 and the second UBM pad 222. The connection pattern 223 may not be exposed out of the uppermost dielectric layer 210. In an embodiment, a UBM pad may be an under bump metallization pad.

The first bump 310 is disposed under the lower surface of the redistribution substrate 200. The first bump 310 is connected to a redistribution pattern 220 that is disposed in a lowermost dielectric layer 210 (e.g., the lowermost dielectric layer may be the dielectric layer closest to the package substrate 100 as shown in FIG. 1). The first bump 310 may be a solder layer or a stack structure of a conductive pillar and a solder layer. The solder layer may include a tin-silver (Sn-Ag) alloy. The conductive pillar may include metal different from the solder layer. The conductive pillar may include copper. The first bump 310 is bonded to the upper substrate pad 120 of the package substrate 100.

The first and second semiconductor chips 410 and 420 include silicon as a main constituent. The coefficient of thermal expansion of silicon is 2.6 ppm/°C to 3.0 ppm/°C. The first semiconductor chip 410 is bonded to the redistribution substrate 200 by the a second bump 320. The first semiconductor chip 410 is electrically and physically connected to the redistribution substrate 200 by the second bump 320. The first semiconductor chip 410 includes a first silicon substrate and a first integrated circuit (not illustrated), and has a first chip pad 411 that is connected to the first integrated circuit, on the lower surface thereof facing the redistribution substrate 200. The second bump 320 is disposed under the first chip pad 411. The second bump 320 may be a solder layer or a stack structure of a conductive pillar and a solder layer. The solder layer may include a tin-silver (Sn-Ag) alloy. The conductive pillar may include metal different from the solder layer. The conductive pillar may include copper. The second bump 320 is bonded to the first UBM pad 221 of the redistribution substrate 200.

The second semiconductor chip 420 is bonded to the redistribution substrate 200 by a third bump 330. The second semiconductor chip 420 is electrically and physically connected to the redistribution substrate 200 by the third bump 330. The second semiconductor chip 420 includes a second silicon substrate and a second integrated circuit (not illustrated), and has a second chip pad 421 that is connected to the second integrated circuit, on the lower surface thereof facing the redistribution substrate 200. The third bump 330 is disposed under the second chip pad 421. The third bump 330 may be a solder layer or a stack structure of a conductive pillar and a solder layer. The solder layer may include a tin-silver (Sn-Ag) alloy. The conductive pillar may include metal different from the solder layer. The conductive pillar may include copper. The third bump 330 is bonded to the second UBM pad 222 of the redistribution substrate 200. The second chip pad 421 of the second semiconductor chip 420 may be connected to the first chip pad 411 of the first semiconductor chip 410 through the third bump 330, the second UBM pad 222, the connection pattern 223, the first UBM pad 221 and the second bump 320.

The first molding layer 510 is disposed on the redistribution substrate 200, and covers the first and second semiconductor chips 410 and 420. The first molding layer 510 covers the side surface of the first semiconductor chip 410 and the side surface of the second semiconductor chip 420. The first molding layer 510 may expose the upper surface of the first semiconductor chip 410 and the upper surface of the second semiconductor chip 420. The upper surface of the first molding layer 510 may be placed on the same plane as the upper surface of the first semiconductor chip 410 and the upper surface of the second semiconductor chip 420.

The first molding layer 510 may extend to fill the space between the first semiconductor chip 410 and the redistribution substrate 200 and the space between the second semiconductor chip 420 and the redistribution substrate 200. The first molding layer 510 may have the shape of a molded underfill (MUF) that fills the space between the first semiconductor chip 410 and the redistribution substrate 200 and the space between the second semiconductor chip 420 and the redistribution substrate 200. The first molding layer 510 may surround the second and third bumps 320 and 330.

The first molding layer 510 may have a coefficient of thermal expansion of 9 ppm/°C to 40 ppm/°C. The first molding layer 510 may have a glass transition temperature of 110°C to 150°C. The first molding layer 510 may have a Young's modulus of 9 GPa to 28 GPa.

The first molding layer 510 may include an epoxy molding compound (EMC). The epoxy molding compound may include resin and filler.

The first underfill layer 610 may fill the space between the package substrate 100 and the redistribution substrate 200. The first underfill layer 610 may surround the first bump 310. The first underfill layer 610 may extend to the side surface of the redistribution substrate 200 and cover the side surface of the redistribution substrate 200. The first underfill layer 610 may extend to the side surface of the first molding layer 510 and cover a part of the side surface of the first molding layer 510. The side surface and lower surface of the redistribution substrate 200 may be covered with the first underfill layer 610. The first underfill layer 610 may be a capillary underfill (CUF).

The coefficient of thermal expansion of the first underfill layer 610 may be equal or approximate to the coefficient of thermal expansion of the dielectric layer 210 of the redistribution substrate 200. The coefficient of thermal expansion of the first underfill layer 610 may be 20 ppm/°C to 40 ppm/°C. In an embodiment, the first underfill layer 610 may alleviate stress that occurs when thermal change is applied due to a mismatch in coefficient of thermal expansion between the package substrate 100 and the redistribution substrate 200, and may suppress or mitigate a crack from occurring in the first bump 310 due to the stress.

The glass transition temperature of the first underfill layer 610 may be lower than the glass transition temperature of the dielectric layer 210 of the redistribution substrate 200. The glass transition temperature of the first underfill layer 610 may be 130°C to 180°C. The first underfill layer 610 may include insulating resin such as epoxy resin.

The second molding layer 520 is disposed on the package substrate 100 and covers the first underfill layer 610 and the first molding layer 510. The second molding layer 520 may cover the side surface of the first molding layer 510, and may expose the upper surface of the first semiconductor chip 410, the upper surface of the second semiconductor chip 420 and the upper surface of the first molding layer 510. The upper surface of the second molding layer 520 may be placed on the same plane as the upper surface of the first semiconductor chip 410, the upper surface of the second semiconductor chip 420 and the upper surface of the first molding layer 510. In an embodiment, because the upper surface of the first semiconductor chip 410 and the upper surface of the second semiconductor chip 420 are exposed, heat generated when the first and second semiconductor chips 410 and 420 operate may be discharged to the outside through the upper surface of the first semiconductor chip 410 and the upper surface of the second semiconductor chip 420.

The second molding layer 520 may have a coefficient of thermal expansion of 9 ppm/°C to 40 ppm/°C. The second molding layer 520 may have a glass transition temperature of 110°C to 150°C. The second molding layer 520 may have a Young's modulus of 9 GPa to 28 GPa.

The second molding layer 520 may include an epoxy molding compound (EMC). The epoxy molding compound may include resin and filler.

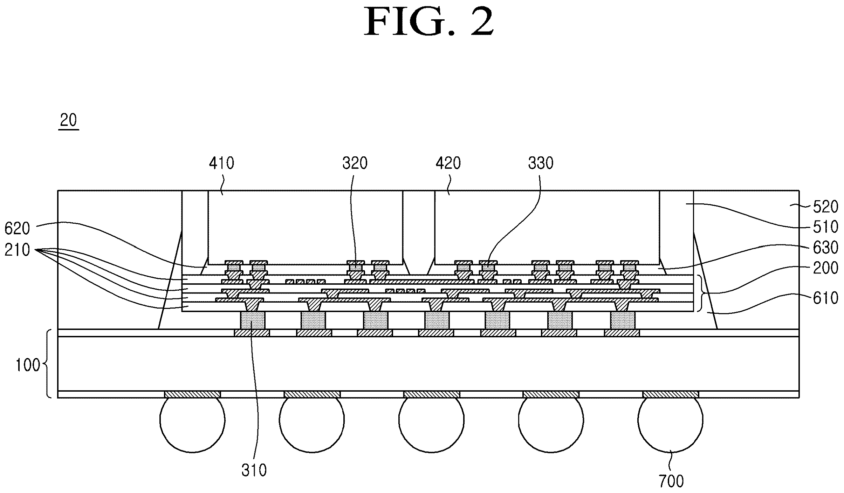

FIG. 2 to FIG. 4 are cross-sectional views illustrating semiconductor packages according to embodiments of the present disclosure.

Referring to FIG. 2, a semiconductor package 20 includes a package substrate 100, a redistribution substrate 200, first and second semiconductor chips 410 and 420, first and second molding layers 510 and 520, first, second and third underfill layers 610, 620 and 630, and an external connection terminal 700. The semiconductor package 20 further includes the second and third underfill layers 620 and 630 compared to the semiconductor package 10 described above with reference to FIG. 1.

The second underfill layer 620 may fill the space between the redistribution substrate 200 and the first semiconductor chip 410. The second underfill layer 620 may be formed separately from the first molding layer 510. The second underfill layer 620 may be a CUF (capillary underfill). The second underfill layer 620 may extend to the side surface of the first semiconductor chip 410 and cover a part of the side surface of the first semiconductor chip 410. The second underfill layer 620 may surround the second bump 320. In an embodiment, the second underfill layer 620 may alleviate stress that occurs when thermal change is applied due to a mismatch in coefficient of thermal expansion between the redistribution substrate 200 and the first semiconductor chip 410, and may suppress or mitigate a crack from occurring in the second bump 320 due to the stress.

The third underfill layer 630 may fill the space between the redistribution substrate 200 and the second semiconductor chip 420. The third underfill layer 630 may be formed separately from the first molding layer 510. The third underfill layer 630 may be a CUF. The third underfill layer 630 may extend to the side surface of the second semiconductor chip 420 and cover a part of the side surface of the second semiconductor chip 420. The third underfill layer 630 may surround the third bump 330. In an embodiment, the third underfill layer 630 may alleviate stress that occurs when thermal change is applied due to a mismatch in coefficient of thermal expansion between the redistribution substrate 200 and the second semiconductor chip 420, and may suppress or mitigate a crack from occurring in the third bump 330 due to the stress.

The coefficient of thermal expansion of the second and third underfill layers 620 and 630 may be equal or approximate to the coefficient of thermal expansion of the dielectric layer 210 of the redistribution substrate 200. The coefficient of thermal expansion of the second and third underfill layers 620 and 630 may be 20 ppm/°C to 40 ppm/°C. The glass transition temperature of the second and third underfill layers 620 and 630 may be lower than the glass transition temperature of the dielectric layer 210 of the redistribution substrate 200. The glass transition temperature of the second and third underfill layers 620 and 630 may be 130°C to 180°C. The second and third underfill layers 620 and 630 may include insulating resin such as epoxy resin.

The first molding layer 510 is disposed on the redistribution substrate 200, and covers the first and second semiconductor chips 410 and 420 and the second and third underfill layers 620 and 630. The first molding layer 510 covers the side surface of the first semiconductor chip 410, the side surface of the second semiconductor chip 420, the side surface of the second underfill layer 620, and the side surface of the third underfill layer 630.

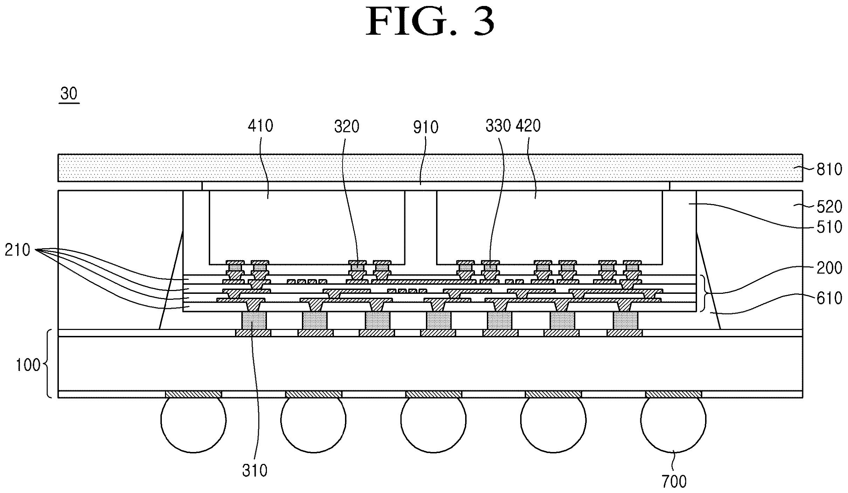

Referring to FIG. 3, a semiconductor package 30 according to an embodiment of the present disclosure includes a package substrate 100, a redistribution substrate 200, first and second semiconductor chips 410 and 420, first and second molding layers 510 and 520, first underfill layer 610, a heat sink 810, and an external connection terminal 700. The semiconductor package 30 further includes the heat sink 810 compared to the semiconductor package 10 described above with reference to FIG. 1. The semiconductor package 30 further includes an adhesive member 910 compared to the semiconductor package 10 described above with reference to FIG. 1.

The heat sink 810 is disposed over the upper surfaces of the first and second semiconductor chips 410 and 420 and the upper surfaces of the first and second molding layers 510 and 520. In an embodiment, the upper surface of the first and second semiconductor chips 410 and 420 are the surfaces that face away from the package substrate 100. An adhesive member 910 is disposed between the first semiconductor chip 410 and the heat sink 810 and between the second semiconductor chip 420 and the heat sink 810, and the heat sink 810 is attached to the first and second semiconductor chips 410 and 420 by the adhesive member 910. The heat sink 810 may include metal. The adhesive member 910 may be a thermal interface material.

Heat generated when the first and second semiconductor chips 410 and 420 operate is transferred to the heat sink 810 through the upper surface of the first semiconductor chip 410 and the upper surface of the second semiconductor chip 420, and may be discharged to the outside through the heat sink 810.

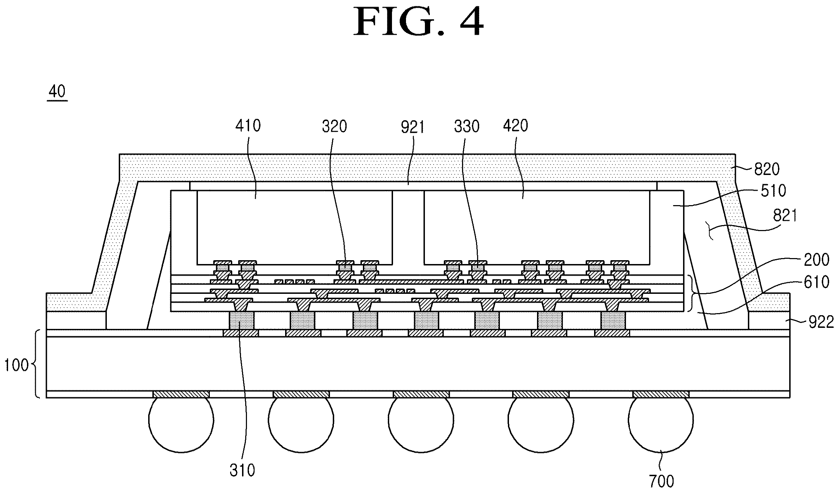

Referring to FIG. 4, a semiconductor package 40 according to an embodiment of the present disclosure includes a package substrate 100, a redistribution substrate 200, first and second semiconductor chips 410 and 420, a first molding layer 510, a first underfill layer 610, a heat dissipation cover 820, and an external connection terminal 700. The semiconductor package 40 does not include the second molding layer 520 and further includes the heat dissipation cover 820 compared to the semiconductor package 10 described above with reference to FIG. 1.

The heat dissipation cover 820 surrounds the redistribution substrate 200, the first and second semiconductor chips 410 and 420, the first molding layer 510 and the first underfill layer 610. The heat dissipation cover 820 has a cavity 821 in which the redistribution substrate 200, the first and second semiconductor chips 410 and 420, the first molding layer 510 and the first underfill layer 610 are accommodated.

A first adhesive member 921 is disposed between the first semiconductor chip 410 and the heat dissipation cover 820 and between the second semiconductor chip 420 and the heat dissipation cover 820. The first adhesive member 921 may attach the heat dissipation cover 820 to the first semiconductor chip 410 and the second semiconductor chip 420. A second adhesive member 922 is disposed between the package substrate 100 and the heat dissipation cover 820. The second adhesive member 922 may attach the heat dissipation cover 820 to the package substrate 100.

The first and second adhesive members 921 and 922 may be a heat transfer material. The heat dissipation cover 820 may include metal. Heat generated when the first and second semiconductor chips 410 and 420 operate is transferred to the heat dissipation cover 820 through the upper surface of the first semiconductor chip 410, the upper surface of the second semiconductor chip 420 and the first adhesive member 921, and may be discharged to the outside through the heat dissipation cover 820.

In the embodiments described above with reference to FIG. 1 to FIG. 4, two semiconductor chips are disposed on a redistribution substrate, but the present disclosure is not limited thereto. The number of semiconductor chips disposed on a redistribution substrate may be one or three or more.

Hereafter, effects according to the present disclosure will be described.

A photosensitive dielectric layer may be used as the dielectric layer of a redistribution substrate. Photosensitive dielectric layers include a positive tone dielectric layer (PTD) and a negative tone dielectric layer (NTD).

The positive tone dielectric layer includes polymer such as phenol and imide at a mass ratio of 15% or less, and includes photoacid generator (PAG). When the positive tone dielectric layer is exposed to light, the photoacid generator (PAG) is photodecomposed to generate acid, and the protective group of polymer is removed by the generated acid, modifying the positive tone dielectric layer to be dissolved in a developer. The positive tone dielectric layer is patterned in such a way that an exposed portion exposed to light is dissolved in a developer to be removed and an unexposed portion not exposed to light is left.

The negative tone dielectric layer includes polyimide at a mass ratio of 50% or more. The negative tone dielectric layer is modified to be insoluble by cross linking when exposed to light. The negative tone dielectric layer is patterned in such a way that an exposed portion exposed to light is left and an unexposed portion is removed by a developer. The negative tone dielectric layer does not contain substances (e.g., photoacid generators, PAGs) that inhibit cross-linking, resulting in a highly cured, dense network structure. Because the negative tone dielectric layer has a dense network structure, the negative tone dielectric layer has a lower coefficient of thermal expansion (CTE) than the positive tone dielectric layer. The negative tone dielectric layer has superior elongation characteristics and tensile strength compared to the positive tone dielectric layer because molecular chains are effectively stretched. The dielectric layer of the redistribution substrate of a semiconductor package according to various embodiments of the present disclosure is composed of a negative tone dielectric layer.

The redistribution substrate serves as a stress buffer between a semiconductor chip and a package substrate. The coefficient of thermal expansion of silicon, the main constituent of the semiconductor chip, is 2.6 ppm/°C to 3.0 ppm/°C, which is significantly different from the coefficient of thermal expansion of an insulating layer that forms the package substrate. Therefore, the stress buffer is required to have a coefficient of thermal expansion that is less than or equal to that of the package substrate. In addition, for an embodiment, it is desirable for the redistribution substrate to have high elongation and tensile strength to act as a stress buffer. As elongation increases and tensile strength increases according to some embodiments, it is possible to become more resistant to physical stress caused by thermal change, and the possibility of a crack to occur due to fatigue failure may decrease.

According to embodiments of the present disclosure, the redistribution substrate including a negative tone dielectric layer has a coefficient of thermal expansion (CTE) of 20 ppm/°C to 50 ppm/°C. Therefore, in an embodiment, the redistribution substrate may serve as a buffer that alleviates mechanical stress caused by a difference in coefficient of thermal expansion between the package substrate including a component having a coefficient of thermal expansion of 15 ppm/°C to 60 ppm/°C at maximum and the semiconductor chip including a component having a coefficient of thermal expansion of 2.6 ppm/°C to 3.0 ppm/°C at minimum. Because, in an embodiment, the redistribution substrate including a negative tone dielectric layer may have a tensile strength of 500 MPa to 700 MPa and an elongation of 50% or more, the redistribution substrate may become more resistant to physical stress due to thermal change, and the possibility of a crack to occur due to fatigue failure may decrease.

According to embodiments of the present disclosure, an underfill layer that fills the space between the package substrate and the redistribution substrate has a coefficient of thermal expansion (CTE) of 20 ppm/°C to 40 ppm/°C. Therefore, in an embodiment, the underfill layer may serve as a buffer that alleviates mechanical stress caused by a difference in coefficient of thermal expansion between the package substrate including a component having a coefficient of thermal expansion of 15 ppm/°C to 60 ppm/°C and the redistribution substrate including a component having a coefficient of thermal expansion of 20 ppm/°C to 50 ppm/°C. Therefore, in an embodiment, the underfill layer may become more resistant to physical stress due to thermal change, and the possibility of a crack to occur due to fatigue failure may decrease.

While the detailed embodiments of the present disclosure are disclosed in the present disclosure, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope.

## Claims

1. A semiconductor package comprising:
a package substrate;
a redistribution substrate bonded to the package substrate by a first bump, the redistribution substrate including a dielectric layer and redistribution patterns;
a first underfill layer filled in the space between the package substrate and the redistribution substrate;
a semiconductor chip bonded to the redistribution substrate by a second bump; and
a first molding layer disposed on the redistribution substrate, and surrounding the semiconductor chip,
wherein the dielectric layer comprises a negative tone dielectric layer that includes polyimide at a mass ratio of 50% or more.

2. The semiconductor package according to claim 1, wherein the dielectric layer has a coefficient of thermal expansion of 20 parts per million per degree Celsius (ppm/°C) to 50 ppm/°C.

3. The semiconductor package according to claim 1, wherein the dielectric layer has a tensile strength of 500 megapascals (MPa) to 700 MPa.

4. The semiconductor package according to claim 1, wherein the dielectric layer has an elongation of 50% or more.

5. The semiconductor package according to claim 1,
wherein the package substrate includes a component that has a coefficient of thermal expansion of 15 ppm/°C to 60 ppm/°C, and the semiconductor chip includes a component that has a coefficient of thermal expansion of 2.6 ppm/°C to 3.0 ppm/°C, and
wherein the first underfill layer has a coefficient of thermal expansion of 20 ppm/°C to 40 ppm/°C.

6. The semiconductor package according to claim 1, wherein the dielectric layer has a glass transition temperature higher than the glass transition temperature of the first underfill layer.

7. The semiconductor package according to claim 1, wherein the dielectric layer has a glass transition temperature of 200 degrees Celsius (°C) to 220°C.

8. The semiconductor package according to claim 1, wherein the first underfill layer has a glass transition temperature of 130°C to 180°C.

9. The semiconductor package according to claim 1, further comprising
a second underfill layer disposed between the redistribution substrate and the semiconductor chip.

10. The semiconductor package according to claim 9, wherein the second underfill layer has a coefficient of thermal expansion of 20 ppm/°C to 40 ppm/°C.

11. The semiconductor package according to claim 9, wherein the second underfill layer has a glass transition temperature lower than the glass transition temperature of the dielectric layer.

12. The semiconductor package according to claim 9, wherein the second underfill layer has a glass transition temperature of 130°C to 180°C.

13. The semiconductor package according to claim 1, wherein the first molding layer is formed to surround the side surface of the semiconductor chip and fill the space between the semiconductor chip and the redistribution substrate.

14. The semiconductor package according to claim 1, wherein the first underfill layer extends to the side surface of the redistribution substrate and covers the side surface of the redistribution substrate.

15. The semiconductor package according to claim 1, further comprising
a second molding layer disposed on the package substrate, and covering the first underfill layer and the first molding layer.

16. The semiconductor package according to claim 15, wherein the first and second molding layers are formed to expose the upper surface of the semiconductor chip.

17. The semiconductor package according to claim 16, further comprising
a heat sink disposed on the upper surface of the semiconductor chip.

18. The semiconductor package according to claim 1, further comprising
a heat dissipation cover having a cavity in which the semiconductor chip, the first underfill layer, the first molding layer and the redistribution substrate are accommodated.

19. A semiconductor package comprising:
a package substrate;
a redistribution substrate bonded to the package substrate by a first bump, and including a dielectric layer and a redistribution pattern; and
a first semiconductor chip bonded to the redistribution substrate by second bump,
wherein the dielectric layer includes a negative tone dielectric layer that includes polyimide at a mass ratio of 50% or more.

20. The semiconductor package according to claim 19, wherein the dielectric layer has a coefficient of thermal expansion of 20 parts per million per degree Celsius (ppm/°C) to 50 ppm/°C.

21. The semiconductor package according to claim 19, wherein the dielectric layer has a tensile strength of 500 megapascals (MPa) to 700 MPa.

22. The semiconductor package according to claim 19, wherein the dielectric layer has an elongation of 50% or more.

23. The semiconductor package according to claim 19, wherein the package substrate includes a component that has a coefficient of thermal expansion of 15 ppm/°C to 60 ppm/°C, and the first semiconductor chip includes a component that has a coefficient of thermal expansion of 2.6 ppm/°C to 3.0 ppm/°C.

24. The semiconductor package according to claim 19, wherein the dielectric layer has a glass transition temperature of 200 degrees Celsius (°C) to 220°C.

25. The semiconductor package according to claim 19, further comprising
a second semiconductor chip bonded to the redistribution substrate by a third bump.

26. The semiconductor package according to claim 25, wherein the redistribution pattern comprises:
a first under bump metallization (UBM) pad to which the second bump is bonded;
a second UBM pad to which the third bump is bonded; and
a connection pattern connecting the first UBM pad and the second UBM pad.
